# FASCICULE DE BREVET EUROPEEN

(11) **EP 1 829 174 B1**
(45) Date de publication et mention de la délivrance du brevet: **09.09.2009**
(21) Numéro de dépôt: 05819221.2
(22) Date de dépôt: 16.12.2005
(51) Int. Cl.: H01S 5/22, H01S 5/24

(54) **LASER SEMICONDUCTEUR DE PUISSANCE A FAIBLES DIVERGENCE ET ASTIGMATISME, ET SON PROCEDE DE FABRICATION**
LEISTUNGS-HALBLEITERLASER MIT GERINGER DIVERGENZ UND GERINGEM ASTIGMATISMUS UND VERFAHREN ZU SEINER HERSTELLUNG
POWER SEMICONDUCTOR LASER WITH LOW DIVERGENCE AND LOW ASTIGMATISM, AND METHOD FOR THE PRODUCTION THEREOF

(30) Priorité: 22.12.2004 FR 0413745
(43) Date de publication de la demande: 05.09.2007
(73) Titulaire: THALES, 92200 Neuilly sur Seine (FR)
(72) Inventeur: KRAKOWSKI, Michel, F-92340 Bourg la Reine (FR); CALLIGARO, Michel, F-78470 Saint Remy les Chevreuse (FR)
(74) Mandataire: Chaverneff, Vladimir
(86) Numéro de dépôt international: PCT/EP2005/056878
(87) Numéro de publication internationale: WO 2006/067098

(56) Documents cités:
- EP-A- 1 312 971
- US-A- 4 803 691
- US-A1- 2002 110 170
- US-A1- 2004 125 846
- US-B1- 6 238 943
- CHEONG J-M ET AL: "High alignment tolerance coupling scheme for multichannel laser diode/singlemode fibre modules using a tapered waveguide array" ELECTRONICS LETTERS, IEE STEVENAGE, GB, vol. 30, no. 18, 1 septembre 1994 (1994-09-01), pages 1515-1516, XP006001045 ISSN: 0013-5194
- EL YUMIN S ET AL: "MONOLITHIC INTEGRATION OF GAINASP/INP COLLIMATING GRIN LENS WITH TAPERED WAVEGUIDE ACTIVE REGION" PROCEEDINGS OF THE INTERNATIONAL CONFERENCE ON INDIUM PHOSPHIDE AND RELATED MATERIALS. HOKKAIDO, MAY 9 - 13, 1995, NEW YORK, IEEE, US, vol. CONF. 7, 9 mai 1995 (1995-05-09), pages 721-724, XP000630704 ISBN: 0-7803-2148-0

## Description

La présente invention se rapporte à un laser semi-conducteur de puissance à faibles divergence et astigmatisme, ainsi qu'à un procédé de réalisation d'un laser de ce type.

Les lasers à semi-conducteur de puissance supérieure à 1 Watt sont généralement des lasers de type à ruban large et, en fonction de la puissance d'émission requise, peuvent être unitaires ou disposés en parallèle pour former des barrettes. Le principal inconvénient de tels lasers est que la distribution en amplitude de leur faisceau émis, dans un plan perpendiculaire à leur face d'émission, est fortement divergente (divergence de l'ordre de 15° dans un plan parallèle aux couches actives) et très inhomogène, ce qui entraîne une baisse de rendement du couplage à une fibre optique. La cause en est l'existence de modes parasites dans la cavité du laser et la présence de phénomènes de « filamentation » (le courant électronique, à l'intérieur du semi-conducteur, passe non pas par toute la section active du semi-conducteur, mais de façon inhomogène).

Pour améliorer l'homogénéité du champ proche de la face d'émission de tels lasers, on a intégré sur la même puce un laser à ruban étroit monomode (agissant comme un filtre) prolongé par une partie évasée agissant en amplificateur. On peut alors émettre des puissances nettement supérieures à 1 Watt, tout en gardant un faisceau transverse monomode. Les lasers connus ont été réalisés selon les deux configurations suivantes. La première consiste à graver dans des couches actives un ruban étroit monomode à guidage transverse par l'indice suivi d'une partie évasée qui est également à guidage transverse par l'indice, « guidage transverse par l'indice » signifiant que le confinement latéral du champ optique est obtenu par une différenciation de l'indice de réfraction entre la zone du ruban étroit et les zones qui la bordent. La seconde configuration comporte également un ruban étroit monomode à guidage transverse par l'indice, mais suivi d'une partie évasée à guidage transverse par le gain. Jusqu'à présent, aucune autre configuration n'a été proposée, car on estimait que seules les deux précitées permettaient de contrôler facilement la qualité du faisceau laser émis. Cependant, ces structures connues sont relativement complexes à réaliser et leur dissipation thermique n'est pas facile à évacuer. On connaît par exemple d'après le brevet US 2004/125846, ou même d'après le document de Cheong et al « High alignment tolerance coupling scheme for multichannel laser diode/single mode fibre modules using a tapered waveguide array » paru dans ELECTRONICS LETTERS, vol 30, no 18, 1er Septembre 1994, pages 1515-1516, un laser du type à ruban étroit prolongé par une partie évasée, mais ce laser est complexe à réaliser (il comporte des étapes de gravure et de recroissance) et ne permet pas un bon confinement du courant électrique circulant dans ce ruban. On connait également des lasers ou des guides d'ondes optiques à confinement optique et isolation électrique d'après les documents EP 1 312 971 A2 et US 2002/0 110 170 A1.

La présente invention a pour objet un laser à semi-conducteur dont le faisceau émis dont le champ lointain (à quelques cm de la face d'émission) ait une répartition en amplitude gaussienne et ait une faible divergence et un faible astigmatisme, et ait une puissance supérieure à 1 W tout en étant stable en température, qui soit facile à réaliser, qui puisse avoir une bonne dissipation thermique et qui puisse être fabriqué par groupes de plusieurs éléments sur le même substrat.

Le procédé de l'invention est un procédé de réalisation d'un laser semi-conducteur, comportant, dans une couche active d'une structure multicouche, un ruban étroit, à guidage transverse par l'indice, dont une première partie est de type monomode, d'une largeur de quelques micromètres, cette première partie étant terminée par une deuxième partie s'évasant depuis la première partie, la structure multicouche de ce laser étant du type à confinements séparés dans un plan perpendiculaire aux plans des couches et comportant une couche active à au moins un puits quantique, et comportant les étapes suivantes:
- croissance épitaxiale d'un substrat et des couches de la structure multicouche;
- dépôt d'un premier contact ohmique sur la couche supérieure de ladite structure ;
- photolithographie et gravure dans les couches superficielles de ladite structure de deux tranchées définissant entre elles lesdites première et deuxième parties du ruban étroit;
- dépôt d'un deuxième contact ohmique sur la face inférieure du substrat ;
et il est caractérisé par le fait qu'il comporte ensuite les étapes suivantes :
- dépôt de polymère dans les tranchées ;
- photolithographie sur la face supérieure du premier contact ohmique à l'aide d'une résine photosensible, laissant subsister de la résine au-dessus d'une zone comprise entre les deux tranchées
- implantation de protons à travers la couche du premier contact dans les zones qui bordent extérieurement les tranchées, la couche de résine empêchant l'implantation dans la zone qu'elle recouvre ;
- dépôt d'une électrode sur la face supérieure de l'ensemble.

On notera que la résine photosensible est également connue sous le nom de « photorésist », et que ce dernier terme sera employé ci-dessous.

Selon une autre caractéristique de l'invention, on réalise plusieurs lasers unitaires côte à côte sur un même substrat et après dépôt de l'électrode sur la face supérieure de l'ensemble, on pratique des chemins de découpe dans cette électrode pour délimiter des lasers unitaires ou des groupes adjacents de lasers unitaires adjacents, et on sépare les lasers unitaires ou groupes de lasers unitaires en suivant les chemins de découpe.

Selon une autre caractéristique de l'invention, on forme sur un même substrat plusieurs mini-barrettes comportant chacune plusieurs lasers unitaires, on creuse dans au moins une partie des couches formées sur le substrat des tranchées de délimitation de mini-barrettes, et l'on remplit ces tranchées de polymère.

Selon une autre caractéristique de l'invention, l'on fixe les lasers unitaires ou les ensembles de lasers unitaires par leur face supérieure sur un radiateur thermique.

Le laser conforme à l'invention est un semi-conducteur de puissance à faibles divergence et astigmatisme à structure multicouche comportant, dans une couche active, à au moins un puits quantitative, de ladite structure, un ruban étroit à guidage transverse par l'indice, dont une première partie, d'une largeur de quelques microns, est de type monomode, cette première partie étant terminée par une deuxième partie s'évasant depuis la première partie, la délimitation de ce ruban étant faite par deux tranchées gravées dans des couches superficielles de la structure multicouche, laquelle est des type à confinements séparés dans un plan perpendiculaire aux plans ses couches, **caractérisé en ce que** la délimitation du ruban est complétée par une implantation de protons dans les zones qui bordent extérieurement les tranchées, ces tranchées étant remplies de polymère.

La présente invention sera mieux comprise à la lecture de la description détaillée d'un mode de réalisation, pris à titre d'exemple non limitatif et illustré par le dessin annexé, sur lequel :
- la figure 1 est une vue simplifiée en perspective d'un laser conforme à l'invention,
- la figure 2 est une vue en coupe schématique montrant les différentes couches de confinement et actives du laser de la figure 1,
- la figure 3 est un ensemble de neuf vues en coupe très simplifiées montrant les différentes étapes de fabrication du laser unitaire de l'invention,
- la figure 4 est un ensemble de dix vues en coupe très simplifiées montrant les différentes étapes de fabrication d'une barrette à plusieurs lasers unitaires de l'invention,
- la figure 5 est une vue schématique de dessus d'un ensemble de barrettes similaires à celle de la figure 4,
- la figure 6 est une vue schématique en perspective d'une barrette similaire à celle de la figure 4, avec une vue agrandie d'un détail, et
- la figure 7 est une vue de dessus simplifiée d'un déflecteur de photons pour un laser conforme à l'invention.

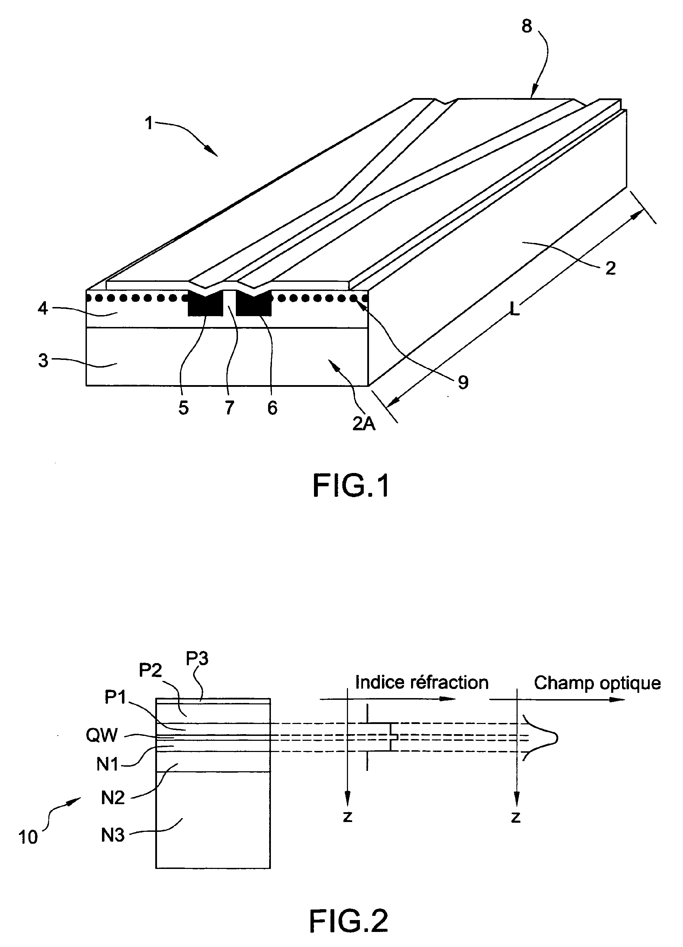

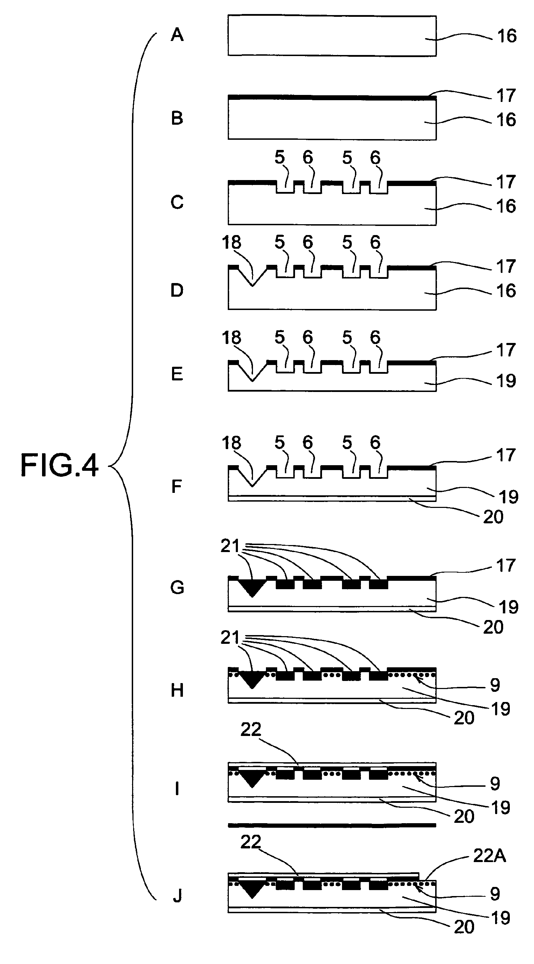

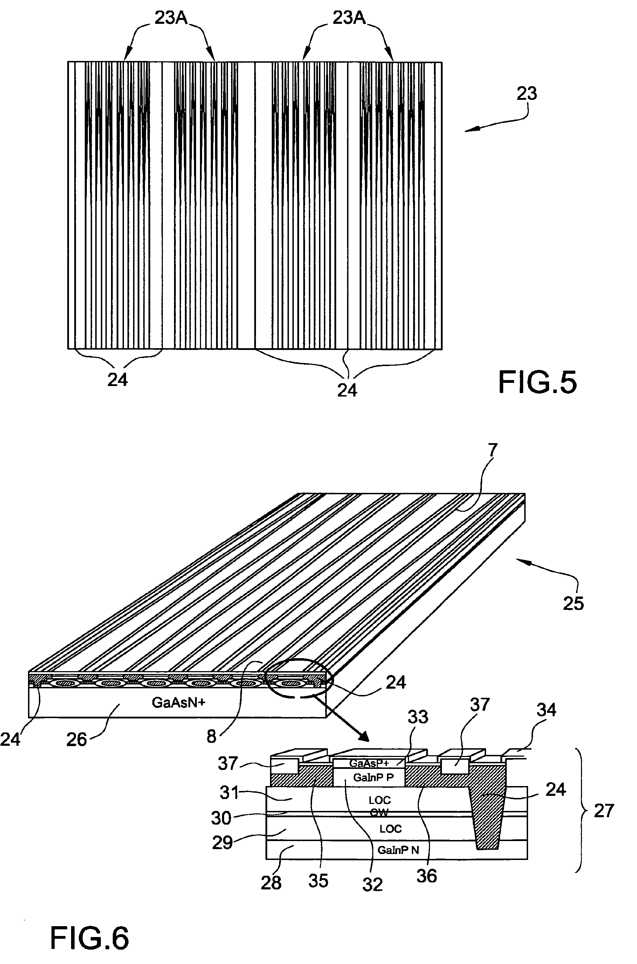

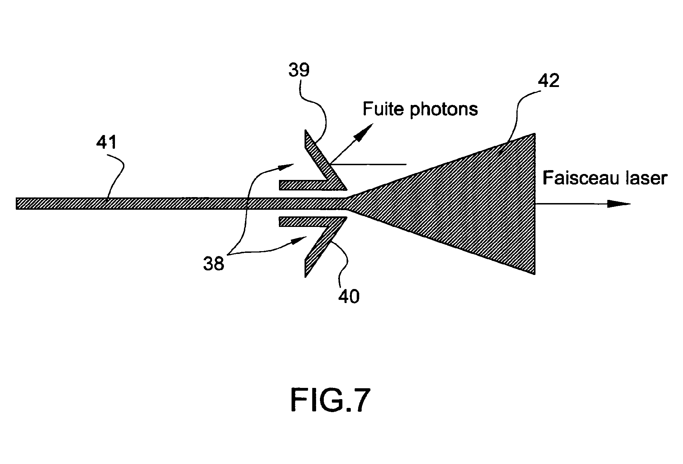

Le laser semi-conducteur 1 représenté en figure 1 est une source laser élémentaire, mais il est bien entendu que l'on peut constituer une barrette comportant plusieurs telles sources élémentaires côte à côte, formées dans le même barreau semi-conducteur, ainsi que représenté en figures 4 à 6. Le laser 1 se présente sous forme d'un barreau 2 semi-conducteur en forme de parallélépipède rectangle. Ce barreau 2 comporte essentiellement un substrat 3 sur lequel est formé un ensemble de couches semi-conductrices 4 dont les détails sont décrits ci-dessous, en particulier en référence aux figures 2 et 6. Dans les couches les plus superficielles situées au-dessus de la couche de puits quantique (voir figures 2 et 6) de l'ensemble 4, on forme, par micro-lithographie et gravure, deux tranchées 5 et 6, qui sont parallèles entre elles et à l'axe longitudinal du barreau 2 sur une première partie de leur parcours, puis s'écartent légèrement l'une de l'autre, sur le reste de leur parcours, définissant ainsi entre elles un « canal de passage de courant » ou ruban étroit monomode 7 qui se prolonge par un évasement 8. L'angle d'ouverture de la partie 8 est d'environ 1 à 2 degrés, et de préférence inférieur à 1°, ce qui assure alors un faible astigmatisme au faisceau laser sortant de cet évasement. Selon un premier exemple de réalisation, la longueur L du barreau est d'environ 2,5 à 3 mm, l'angle d'ouverture de la partie 8 est d'environ 2° et sa longueur est d'environ 1 mm. Selon un autre exemple de réalisation, la longueur L est également d'environ 2,5 à 3 mm, l'angle d'ouverture de la partie 8 est d'environ 0,64° et sa longueur est d'environ 2,2 mm. La largeur du ruban 7 est de quelques microns. A l'extérieur de l'espace compris entre les parois extérieures des tranchées 5 et 6, on procède à une implantation de protons (symbolisés par des points 9) dans les couches superficielles de l'ensemble 4, par exemple avec une énergie d'environ 100 keV, afin de rendre ces parties de couches électriquement isolantes et forcer ainsi, lors du fonctionnement du laser, le courant électrique qui lui est amené par ses électrodes à passer dans le canal 7, 8. Dans cette structure, le ruban 7 est à guidage monomode transverse et stabilise le mode du faisceau émis par l'évasement 8 qui joue le rôle d'amplificateur. Dans le cas où l'angle de la partie évasée 8 est supérieur à 2°, on forme avantageusement un déflecteur tel que celui décrit ci-dessous en référence à la figure 7. Les faces frontales du barreau 2 (perpendiculaires à la direction des tranchées 5) sont obtenues par clivage de ce barreau, après dépôt des ses électrodes, par clivage. L'une de ces faces (la face 2A visible sur le dessin) reçoit un traitement à haute réflectivité, tandis que la face opposée (face de sortie du faisceau laser) reçoit un traitement anti-reflets.

On a schématiquement représenté en figure 2 la structure semi-conductrice du laser de l'invention. Cette structure est du type à confinements séparés dans un plan perpendiculaire aux plans des couches, avec une couche active à au moins un puits quantique. Elle est formée sur un substrat N3 de type N fortement dopé, par exemple en GaAs. Sur ce substrat, on forme successivement les couches suivantes :
- Une couche N2 de confinement optique et électrique, de type N, à faible indice. Elle peut être en GaInP, GaAlAs, AlGaInP, etc.
- Une couche N1 de confinement électrique et optique, de type N, à fort indice. Elle peut être en GaInAsP, GaInP, etc.
- Une couche QW, qui est une couche active à puits quantique.
- Une couche P1 de confinement électrique et optique de type P, à indice fort. Elle peut être en GaInAsP, GaInP, etc.
- Une couche P2 de confinement optique de type P, à faible indice. Elle peut être en GaInP, GaAlAs, AlGaInP, etc.
- Une couche P3 de contact électrique de type P, fortement dopée, par exemple en GaAs.

En correspondance avec le schéma de la structure qui vient d'être décrite, on a représenté, sur la figure 2, à droite de cette structure, la courbe d'évolution de l'indice de réfraction des différentes couches qui la composent, ainsi que la courbe d'évolution de l'intensité du champ optique, le long d'une direction perpendiculaire aux plans de ces couches.

On réalise ainsi, grâce à la formation des tranchées 5 et 6, un laser de type ruban à guidage, dans des plans parallèles aux plans des couches, par la partie réelle de l'indice de réfraction du matériau semi-conducteur traversé. La gravure de ces tranchées peut être réalisée de façons différentes, en fonction de la nature du matériau de la couche P2. Si cette couche est en GaInP, la gravure se fait selon un procédé chimique humide, avec auto- alignement par rapport au dessin du métal du contact ohmique (déposé sur la couche supérieure de l'ensemble 4), ceci en raison de la grande sélectivité de vitesse de gravure de l'alliage quaternaire de la couche P1, la gravure étant généralement arrêtée à la limite entre les couches P2 et P1 (si la différence entre l'indice de la couche P1 et celui de la couche P2 est suffisamment importante). Dans le cas où la couche P1 est en GaAlAs, la gravure est réalisée selon un procédé de gravure sèche par plasma (de type RIE, ICP,...) auto- alignée par rapport au dessin du métal du contact ohmique (déposé sur la couche supérieure de l'ensemble 4). Les tranchées ainsi réalisées sont remplies de polymère et rendues coplanaires avec la couche de contact ohmique précitée. Le matériau polymère joue le rôle d'isolation électrique des zones 7 et 8 par rapport au matériau semi-conducteur des mêmes couches, à l'extérieur des tranchées 5 et 6.

La structure laser de l'invention qui vient d'être décrite peut être fixée par sa face supérieure (la plus proche de la couche P3) sur un radiateur thermique, ce qui optimise sa dissipation thermique.

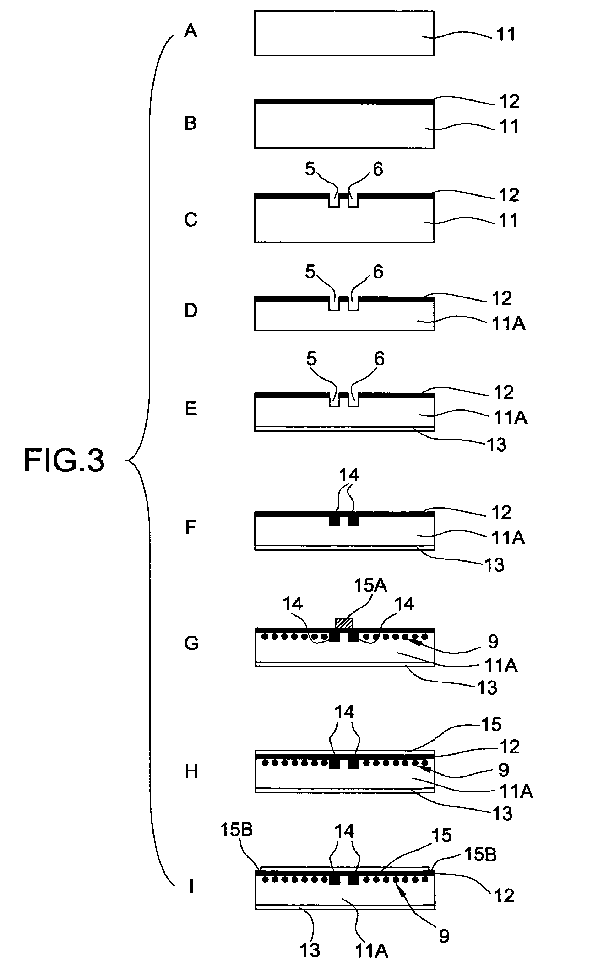

En figure 3, on a schématiquement représenté les neuf premières étapes de réalisation de la structure du laser de l'invention, référencées A à I, parmi les douze principales. Ces étapes sont, dans l'ordre :
(A) : croissance épitaxiale du substrat et des couches suivantes, telles que celles représentées en figure 2, l'ensemble étant référencé 11,
(B) : dépôt d'un contact ohmique 12 sur la couche P3 de la structure 11,
(C) : photolithographie et gravure des deux tranchées 5 et 6,
(D) : amincissement du substrat (du côté de la face opposée à la couche 15), l'ensemble de la structure semi-conductrice est maintenant référencé 11A,
(E) : dépôt d'un contact ohmique 13 sur la face inférieure du substrat, et recuit de ce contact,
(F) : dépôt de polymère 14 dans les tranchées 5 et 6, puis élimination du surplus afin d'obtenir une surface plane, coplanaire avec la face supérieure du dépôt 12,
(G) : photolithographie sur la face supérieure de la couche 12, puis implantation de protons (9) afin de bien isoler les parties 7 et 8. La zone se trouvant sous la partie 15A de photorésist subsistant après photolithographie (entre les deux tranchées 5 et 6) ne comporte pas de protons, puis élimination de la partie 15A,
(H) : dépôt d'une électrode 15 sur les couches 12 et 14,
(I) : photolithographie et ouverture des chemins de découpe 15B entre lasers unitaires adjacents ou groupes adjacents de lasers élémentaires,

- clivage des faces d'émission et à haute réflectivité,
- traitement anti-reflets des faces d'émission laser,
- traitement haute réflectivité des faces opposées aux faces d'émission,
- séparation des lasers élémentaires (ou des barrettes de lasers élémentaires), en suivant les chemins de découpe 15B.

Les figures 4 à 6 se rapportent aux étapes de fabrication d'une ou de plusieurs mini-barrettes comportant chacune plusieurs lasers élémentaires tel que celui représenté en figure 1 et réalisées toutes sur le même substrat. Les séparations optiques entre mini-barrettes adjacentes sont réalisées par formation de tranchées à flancs non perpendiculaires aux plans des couches actives dans les couches actives (voir figure 6). Ces étapes de fabrication sont les suivantes, dans l'ordre :
(A) : croissance épitaxiale du substrat et des couches suivantes, telles que celles représentées en figure 2, l'ensemble étant référencé 16,
(B) : dépôt d'un contact ohmique 17 de type P+ sur la couche P3 de la structure 16,
(C) : photolithographie et gravure, pour chaque laser élémentaire, des deux tranchées 5 et 6,
(D) : photolithographie et gravure des séparations 18 entre mini-barrettes adjacentes,
(E) : amincissement du substrat (du côté de la face opposée à la couche 17), l'ensemble de la structure semi-conductrice est maintenant référencé 19,
(F) : dépôt d'un contact ohmique 20 sur la face inférieure du substrat, et recuit de ce contact,
(G) : dépôt de polymère 21 dans les tranchées 5, 6 et 18, puis élimination du surplus afin d'obtenir une surface plane, coplanaire avec la face supérieure du dépôt 17,
(H) : photolithographie sur la face supérieure de la couche 17, puis implantation de protons (9) afin de bien isoler les parties 7 et 8 des zones environnantes,
(I) : dépôt d'une électrode 22 sur les couches 17 et 21,
(J) : photolithographie et ouverture des chemins de découpe entre lasers unitaires adjacents ou groupes adjacents de lasers élémentaires,

- clivage des faces d'émission et à haute réflectivité,
- traitement anti-reflets des faces d'émission laser,
- traitement haute réflectivité des faces opposées aux faces d'émission,
- séparation des mini-barrettes de lasers élémentaires.

Sur la figure 5, on a représenté une vue de dessus partielle d'un ensemble 23 de quatre mini-barrettes 23A formées sur le même substrat avec leurs tranchées de séparation optique 24.

Sur la vue en perspective de la figure 6, on a représenté une des mini-barrettes de la figure 5, référencée 25 et formée sur un substrat 26 par exemple en GaAs de type N+. Sur ce substrat on forme un ensemble de couches actives semi-conductrices 27. Cet ensemble comporte, dans l'ordre à partir du substrat 26, une couche 28 par exemple en GalnP, de type N, une couche 29 formant une première grande cavité optique (« Large Optical Cavity » en anglais) correspondant à l'ensemble des couches N2 et N1 de la figure 2), un puits quantique 30, une deuxième grande cavité optique 31 correspondant à la couche P1 de la figure 2, une couche 32 de type P, par exemple en GaInP de type P, une couche 33, par exemple en GaAs, de type P+, et une couche 34 formant électrode, par exemple en PtCrAuPtAu déposée sur toute la surface supérieure de la mini-barrette après gravure des tranchées décrites ci-après. Comme on le remarque sur la figure 6, la couche 34 n'est pas plane, car elle suit le profil des couches sous-jacentes. Les tranchées 35, 36 de délimitation du ruban laser et de son évasement sont creusées dans les couches 32 et 33, alors que les tranchées 24 de délimitation des mini-barrettes sont creusées dans l'ensemble des couches 29 à 33, et partiellement dans l'épaisseur de la couche 28. Les flancs des tranchées 24 sont perpendiculaires aux plans des couches semi-conductrices, au niveau des couches 32 et 33, et obliques au niveau des autres couches 28 à 31 en formant entre eux un angle de quelques degrés, par exemple compris entre 0,5 et 2° environ. Toutes les tranchées 24, 35 et 36 sont remplies de polymère. On implante des protons dans les zones 37 des couches 32 et 33 bordant extérieurement les tranchées 35, 36. L'implantation ne s'arrête pas nécessairement à la couche 32.

Sur le schéma de la figure 7, on a représenté en particulier les détails de réalisation d'un réflecteur 38. Ce réflecteur comporte deux éléments 39, 40 ayant, en vue de dessus, une forme en « V » et disposés symétriquement de part et d'autre du ruban laser 41, près de sa jonction avec la partie évasée 42. L'une des branches de chaque « V » est parallèle au ruban 41, tandis que l'autre branche forme un angle inférieur à 90° par rapport à la première, le sommet de chaque « V » étant dirigé vers la partie évasée 42. Les deux « V » de ce réflecteur sont réalisés en creusant dans les couches actives se trouvant au-dessus du puits quantique des « tranchées » à parois perpendiculaires aux plans de ces couches et dont la section, dans un plan parallèle au plan des couches a la forme en « V » décrite ci-dessus. Ces tranchées sont ensuite remplies d'une matière polymère, ce qui les rend électriquement isolantes.

Ainsi, grâce à l'invention, il est possible de réaliser des sources laser élémentaires ou groupées en barrettes, et de les fixer par leur face supérieure (celle 18) sur un radiateur thermique approprié, ce qui améliore nettement l'évacuation thermique en fonctionnement par rapport aux sources de l'art antérieur, qui ne pouvaient être fixées sur un radiateur que par leur embase.

Selon des exemples de réalisation de l'invention, on a obtenu des lasers élémentaires ayant de longueurs d'onde comprises entre 0,7 et 1,1 µm avec des puits ou boites (dites « Qdots ») quantiques sur substrat en GaAs, des longueurs d'onde comprises entre 1,1 et 1,8 µm avec des puits ou boites quantiques sur substrat en InP, des longueurs d'onde comprises entre 2 et 2,5 µm pour des puits ou boites quantiques sur substrat en GaSb, et des longueurs d'onde comprises entre 3 et plus de 12 µm avec des sources laser de type QCL.

Dans ces exemples de réalisation, la largeur constante des tranchées délimitant le ruban et son évasement était d'environ 6 à 7 µm, la largeur des rubans de 3 à 4 µm, la longueur des rubans de 500 µm au maximum et celle des parties évasées de 2500 à 3000 µm au maximum et leur angle d'évasement d'environ 0,64°, le pas des lasers élémentaires d'une même mini-barrette d'environ 50 µm.

En général, pour tous ces exemples de réalisation, la divergence du faisceau émis était de l'ordre de 2° à mi-hauteur de sa courbe d'amplitude), et la puissance du faisceau à la sortie de la partie évasée supérieure ou égale à 1 W environ.

Selon une variante de l'invention (non représentée), l'axe de la partie évasée 8 peut ne pas être aligné sur l'axe du ruban 7, mais faire avec celui-ci un angle de quelques degrés (dans un plan parallèle à celui des couches actives), afin de diminuer la réflectivité dans la face de sortie du faisceau laser.

## Revendications

1. Procédé de réalisation d'un laser semi-conducteur à guidage transverse par l'indice, comportant, dans une couche active (4) d'une structure multicouche (11), un ruban étroit, à guidage transverse par l'indice, dont une première partie (7) est de type monomode d'une largeur de quelques micromètres, cette première partie étant terminée par une deuxième partie (8) s'évasant depuis la première partie, la structure multicouche (11) de ce laser étant du type à confinements séparés dans un plan perpendiculaire aux plans des couches et comportant une couche active à au moins un puits quantique, et comportant les étapes suivantes:
- croissance épitaxiale d'un substrat dans les zones qui bordent extérieurement les tranchées, et des couches de la structure multicouche (11) ;
- dépôt d'un premier contact ohmique (12) sur la couche supérieure de ladite structure ;
- photolithographie et gravure dans des couches superficielles de ladite structure (11) de deux tranchées (5, 6) définissant entre elles lesdites première et deuxième parties du ruban étroit;
- dépôt d'un deuxième contact ohmique (13) sur la face inférieure du substrat ;
**caractérisé par le fait qu'**il comporte ensuite les étapes suivantes :
- dépôt de polymère (14) dans les tranchées ;
- photolithographie sur la face supérieure du premier contact ohmique à l'aide d'une résine photosensible, laissant subsister de la résine (15A) au-dessus d'une zone comprise entre les deux tranchées ;
- implantation de protons (9) à travers la couche du premier contact, dans les zones qui bordent extérieurement les tranchées, la couche de résine empêchant l'implantation dans la zone qu'elle recouvre ;
- dépôt d'une électrode (15) sur la face supérieure de l'ensemble.

2. Procédé selon la revendication 1, **caractérisé par le fait que** l'on réalise plusieurs desdits lasers unitaires côte à côte sur un même substrat et qu'après dépôt de l'électrode (15) sur la face supérieure de l'ensemble, on pratique des chemins de découpe (15B) dans cette électrode pour délimiter des lasers unitaires ou des groupes adjacents de lasers unitaires adjacents, et qu'on sépare les lasers unitaires ou groupes de lasers unitaires en suivant les chemins de découpe.

3. Procédé selon la revendication 1 ou 2, **caractérisé par le fait que** l'on forme sur le même substrat plusieurs mini-barrettes comportant chacune plusieurs desdits lasers unitaires, que l'on creuse dans au moins une partie des couches formées sur le substrat des tranchées (24) de délimitation de mini-barrettes, et que l'on remplit ces tranchées de polymère.

4. Procédé selon l'une des revendications précédentes, **caractérisé par le fait que** l'on fixe les lasers unitaires ou les ensembles de lasers unitaires par leur face supérieure sur un radiateur thermique.

5. Laser semi-conducteur de puissance à faibles divergence et astigmatisme à structure mutticouche comportant, dans une couche active (4), au moins un puits quantique de ladite structure, un ruban étroit, à guidage transverse par l'indice, dont une première partie (7), d'une largeur de quelques microns, est de type monomode, cette première partie étant terminée par une deuxième partie (8) s'évasant depuis la première partie, la délimitation de ce ruban étant faite par deux tranchées (35, 36) gravées dans des couches superficielles de la structure multicouche (32, 33), laquelle est du type à confinements séparés dans un plan perpendiculaire aux plans des couches, **caractérisé en ce que** la délimitation du ruban est complétée par une implantation de protons (9) dans les zones (37) qui bordent extérieurement les tranchées, ces tranchées étant remplies de polymère.

6. Laser selon la revendication 5, **caractérisé en ce que** les deux parties du ruban sont formées dans la couche active (4) située au-dessus du puits quantique (QW).

7. Laser selon l'une des revendications 5 ou 6, **caractérisé en ce qu'**il comporte, au niveau de la première partie du ruban un déflecteur de photons parasites (9).

8. Laser selon la revendication 7, **caractérisé en ce que** le déflecteur comporte deux tranchées (39, 40) en forme de « V » disposées de part et d'autre de la première partie du ruban et que ces tranchées sont remplies de

9. Laser selon l'une des revendications 5 à 8, **caractérisé en ce qu'**il est fixé sur un radiateur thermique par sa face opposée au substrat (26).

10. Mini-barrette laser comportant plusieurs lasers élémentaires, **caractérisé en ce que** les lasers élémentaires sont des lasers selon l'une des revendications 5 à 9.

11. Assemblage de mini- barrettes comportant chacune plusieurs lasers élémentaires et formées sur le même substrat (26), **caractérisé en ce que** les lasers élémentaires sont des lasers selon l'une des revendications 5 à 9 et **en ce que** la séparation entre mini- barrettes adjacentes est assurée à chaque fois par une tranchée (24) de séparation optique formée dans les couches semi-conductrices et remplie de polymère.

12. Assemblage selon la revendication 11, **caractérisé en ce que** les flancs de chaque tranchée de séparation optique font entre eux un angle de quelques degrés.

## Claims

1. Method of producing a semiconductor laser (1) comprising, in an active layer (4) of a multilayer structure (11), a narrow stripe, with transverse index guiding, a first part (7) of which is of single-mode type, having a width of a few microns, this first part terminating in a second part (8) flaring out from the first part, the multilayer structure (11) of this laser being of the type with separate confinements in a plane perpendicular to the plane of the layers and including an active layer with at least one quantum well, and comprising the following steps:
- epitaxial growth of a substrate (3) and the layers of the multilayer structure (11);
- deposition of a first ohmic contact (12) on the upper layer of said structure;
- photolithography and etching in surface layers of said structure (11) of two trenches (5, 6) defining between them said first and second parts of the narrow stripe;
- deposition of a second ohmic contact (13) on the underside of the substrate;
**characterized in that** it then comprises the following steps:
- deposition of a polymer (14) in the trenches;
- photolithography on the upper face of the first ohmic contact with the aid of a photoresist, leaving some photoresist (15A) to remain on top of a zone lying between the two trenches;
- proton implantation (9) through the layer of the first contact in the zones that border the trenches to the outside, the photoresist layer preventing implantation in the zone that it covers; and
- deposition of an electrode (15) on the upper face of the assembly.

2. Method according to Claim 1, **characterized in that** several of said unitary lasers are produced side by side on one and the same substrate and **in that**, after deposition of the electrode (15) on the upper face of the assembly, dicing paths (15B) are made in this electrode in order to define unitary lasers or adjacent groups of adjacent unitary lasers and the unitary lasers or groups of unitary lasers are separated along the dicing paths.

3. Method according to Claim 1 or 2, **characterized in that** several mini-arrays are formed on the same substrate, each comprising several of said unitary lasers, **in that** mini-array bounding trenches (24) are cut into at least some of the layers formed in the substrate and **in that** these trenches are filled with a polymer.

4. Method according to one of the preceding claims, **characterized in that** the unitary lasers or the sets of unitary lasers are fastened via their upper face to a heat sink.

5. High-power semiconductor laser having low divergence and low astigmatism of multilayer structure comprising, in an active layer (4), having at least one quantum well, of said structure, a narrow stripe (2), with transverse index guiding, a first part (7) of which, having a width of a few microns, is of single-mode type, this first part terminating in a second part (8) flaring out from the first part, this stripe being bounded by two trenches (35, 36) etched in surface layers of the multilayer structure (32, 33), which is of the type having separate confinements in a plane perpendicular to the plane of the layers, **characterized in that** the bounding of the stripe is completed by proton implantation (9) in the zones (37) that border the trenches to the outside, these trenches being filled with a polymer.

6. Laser according to Claim 5, **characterized in that** the two parts of the stripe are formed in the active layer (4) lying above the quantum well (QW).

7. Laser according to either of Claims 5 and 6, **characterized in that** it includes a parasitic photon deflector (9) in the first part of the stripe.

8. Laser according to Claim 7, **characterized in that** the deflector comprises two "V"-shaped trenches (39, 40) placed on either side of the first part of the stripe and **in that** these trenches are filled with a polymer.

9. Laser according to one of Claims 5 to 8, **characterized in that** it is fastened to a heat sink via its face on the opposite side from the substrate (26).

10. Laser mini-array comprising several elementary lasers, **characterized in that** the elementary lasers are lasers according to one of Claims 5 to 9.

11. Assembly of mini-arrays, each comprising several elementary lasers and formed on the same substrate (26), **characterized in that** the elementary lasers are lasers according to one of Claims 5 to 9 and **in that** the separation between adjacent mini-arrays is provided each time by an optical separating trench (24) that is formed in the semiconductor layers and is filled with a polymer.

12. Assembly according to Claim 11, **characterized in that** the sidewalls of each optical separating trench make an angle of several degrees between them.

## Patentansprüche

1. Verfahren zur Herstellung eines Halbleiterlasers (1), der in einer aktiven Schicht (4) eines Mehrschichtaufbaus (11) einen schmalen Streifen mit transversaler Indexführung aufweist, von dem ein erster Teil (7) vom Monomodentyp mit einer Breite von einigen Mikrometern ist, wobei dieser erste Teil in einem zweiten Teil (8) endet, der sich ab dem ersten Teil ausweitet, wobei der Mehrschichtaufbau (11) dieses Lasers vom Typ mit getrennten Einschlüssen in einer Ebene lotrecht zu den Ebenen der Schichten ist und eine aktive Schicht mit mindestens einem Quantentrog aufweist, und das die folgenden Schritte aufweist :
- epitaxiales Wachstum eines Substrats (3) und der Schichten des Mehrschichtaufbaus (11);
- Aufbringen eines ersten Ohmschen Kontakts (12) auf die obere Schicht des Aufbaus;
- Photolithographie und Gravur in Oberflächenschichten des Aufbaus (11) von zwei Gräben (5, 6), die den ersten und den zweiten Teil des schmalen Streifens zwischen sich definieren;
- Aufbringen eines zweiten Ohmschen Kontakts (13) auf die Unterseite des Substrats;
**dadurch gekennzeichnet, dass** es anschließend die folgenden Schritte aufweist :
- Einbringen von Polymer (14) in die Gräben;
- Photolithographie auf der Oberseite des ersten Ohmschen Kontakts mit Hilfe eines lichtempfindlichen Harzes, wobei Harz (15A) oberhalb einer zwischen den zwei Gräben liegenden Zone bestehen gelassen wird;
- Protonenimplantation (9) durch die Schicht des ersten Kontakts hindurch in die Zonen, die die Gräben außen umranden, wobei die Harzschicht die Implantation in der Zone verhindert, die sie bedeckt;
- Aufbringen einer Elektrode (15) auf die Oberseite der Einheit.

2. Verfahren nach Anspruch 1, **dadurch gekennzeichnet, dass** mehrere der Einzellaser nebeneinander auf dem gleichen Substrat hergestellt werden, und dass nach Aufbringen der Elektrode (15) auf die Oberseite der Einheit Schnittwege (15B) in dieser Elektrode ausgeführt werden, um Einzellaser oder benachbarte Gruppen von benachbarten Einzellasern zu begrenzen, und die Einzellaser oder Gruppen von Einzellasern entlang der Schnittwege getrennt werden.

3. Verfahren nach Anspruch 1 oder 2, **dadurch gekennzeichnet, dass** auf dem gleichen Substrat mehrere Minileisten geformt werden, die je mehrere der Einzellaser aufweisen, dass in mindestens einem Teil der auf dem Substrat geformten Schichten Gräben (24) zur Begrenzung von Minileisten ausgehöhlt werden, und dass diese Gräben mit Polymer gefüllt werden.

4. Verfahren nach einem der vorhergehenden Ansprüche,
**dadurch gekennzeichnet, dass** die Einzellaser oder die Gruppen von Einzellasern über ihre Oberseite an einem Temperaturstrahler befestigt werden.

5. Leistungs-Halbleiterlaser von geringer Divergenz und geringem Astigmatismus mit Mehrschichtaufbau, der in einer aktiven Schicht (4) mit mindestens einem Quantentrog des Aufbaus einen schmalen Streifen mit transversaler Indexführung aufweist, von dem ein erster Teil (7) einer Breite von einigen Mikron vom Monomodentyp ist, wobei dieser erste Teil in einem zweiten Teil (8) endet, der sich ab dem ersten Teil ausweitet, wobei die Begrenzung dieses Streifens von zwei Gräben (35, 36) hergestellt wird, die in Oberflächenschichten des Mehrschichtaufbaus (32, 33) eingegraben sind, der vom Typ mit getrennten Einschlüssen in einer Ebene lotrecht zu den Ebenen der Schichten ist,
**dadurch gekennzeichnet, dass** die Begrenzung des Streifens durch eine Protonenimplantation (9) in den Zonen (37) vervollständigt wird, die die Gräben außen umranden, wobei diese Gräben mit Polymer gefüllt sind.

6. Laser nach Anspruch 5, **dadurch gekennzeichnet, dass** die zwei Teile des Streifens in der aktiven Schicht (4) geformt werden, die sich oberhalb des Quantentrogs (QW) befindet.

7. Laser nach einem der Ansprüche 5 oder 6, **dadurch gekennzeichnet, dass** er in Höhe des ersten Teils des Streifens eine Ablenkeinrichtung (9) für parasitäre Photonen aufweist.

8. Laser nach Anspruch 7, **dadurch gekennzeichnet, dass** die Ablenkeinrichtung zwei Gräben (39, 40) in Form eines "V" aufweist, die zu beiden Seiten des ersten Teils des Streifens angeordnet sind, und dass diese Gräben mit Polymer gefüllt sind.

9. Laser nach einem der Ansprüche 5 bis 8, **dadurch gekennzeichnet, dass** er mit seiner dem Substrat (26) entgegengesetzten Seite an einem Temperaturstrahler befestigt ist.

10. Mini-Laserleiste, die mehrere Elementarlaser aufweist, **dadurch gekennzeichnet, dass** die Elementarlaser Laser nach einem der Ansprüche 5 bis 9 sind.

11. Anordnung von Minileisten, die je mehrere Elementarlaser aufweisen und auf dem gleichen Substrat (26) geformt sind, **dadurch gekennzeichnet, dass** die Elementarlaser Laser nach einem der Ansprüche 5 bis 9 sind, und dass die Trennung zwischen benachbarten Minileisten jedes Mal durch einen optischen Trenngraben (24) gewährleistet wird, der in den Halbleiterschichten geformt und mit Polymer gefüllt ist.

12. Anordnung nach Anspruch 11, **dadurch gekennzeichnet, dass** die Seiten jedes optischen Trenngrabens zwischen sich einen Winkel von einigen Grad bilden.
